# EUROPEAN PATENT APPLICATION

(11) **EP 1 857 488 A1**
(43) Date of publication of application: **21.11.2007**
(21) Application number: 06712317.4
(22) Date of filing: 25.01.2006
(51) Int. Cl.: C08G 77/44, C08L 83/10, H01L 23/29, H01L 23/31, H01L 29/744, H01L 29/861, H01L 31/12, H01L 33/00

(54) **HIGHLY HEAT-RESISTANT SYNTHETIC POLYMER COMPOUND AND HIGH WITHSTAND VOLTAGE SEMICONDUCTOR DEVICE**

(30) Priority: 27.01.2005 JP 2005019877
(71) Applicant: THE KANSAI ELECTRIC POWER CO., INC., Osaka-shi, Osaka 530-8270 (JP); Adeka Corporation, Tokyo 116-0012 (JP)
(72) Inventor: SUGAWARA, Yoshitaka, THE KANSAI ELECTRIC POWER CO, Osaka-shi, Osaka, 5308270 (JP); SHOJI, Yoshikazu, Arakawa-ku, Tokyo, 116-0012 (JP)
(74) Representative: Stoner, Gerard Patrick
(86) International application number: PCT/JP2006/301122
(87) International publication number: WO 2006/080338

(57) **Abstract**

The outer surface of a wide-gap semiconductor device is covered with a synthetic polymer compound. The synthetic polymer compound is formed by linking a plurality of third organosilicon polymers through covalent bonding which is formed by addition reaction, and has a three-dimensional steric structure. The third organosilicon polymers are obtained by liking one or more kinds of first organosilicon polymers having a bridge structure formed by siloxane bonds (Si-O-Si bonds) with one or more kinds of second organosilicon polymers having a linear structure formed by siloxane bonds. Insulating ceramic fine particles having hign heat conductivity are preferably mixed with the synthetic polymer compound.

## Description

### TECHNICAL FIELD

The present invention relates to a synthetic polymer compound having high heat resistance and to a high withstand voltage power semiconductor device covered with the synthetic polymer compound and having high heat resistance and excellent heat dissipation.

### BACKGROUND ART

In a power semiconductor device dealing with relatively high power, since the semiconductor device is heated to high temperature by the heat generated when it is energized with high power, the device is required to have high heat resistance. Most of the currently available power semiconductor devices are silicon (Si) power semiconductor devices, and the heat resistant limit temperature of the Si power semiconductor devices is usually 150°C. At present, attempts at raising the heat resistant limit temperature of Si power semiconductor devices to approximately 200°C have been promoted.
On the other hand, attempts have been made to configure power semiconductor devices by using wide-gap semiconductor materials, such as silicon carbide (hereafter referred to as SiC). In comparison with Si, the wide-gap semiconductor materials, such as SiC, have excellent physical characteristics: large energy gap and high dielectric breakdown strength by approximately one order of magnitude, thereby being suited for use in highly heat-resistant and high withstand voltage power semiconductor devices.

As an example of conventional highly heat-resistant and high withstand voltage power semiconductor devices comprising SiC, a SiC diode mentioned below is disclosed in Nonpatent Document 1 described below. In this SiC diode, a pn junction into which electric charges are injected is formed on a SiC substrate by using an epitaxial film formed by the epitaxial growth technology. In addition, after the epitaxial film in the end regions of the substrate is removed by mesa etching, termination portions for relaxing electric fields are formed by ion implantation. More specifically, by mesa etching treatment to a depth of approximately 1 µm, a p-type epitaxial layer having a thickness of 0.7 µm is removed, and an inorganic film made of silicon dioxide or the like and having a thickness of 0.4 µm is formed as a passivation film. As a result, a SiC diode element having a high withstand voltage of 12 to 19 kV is obtained.

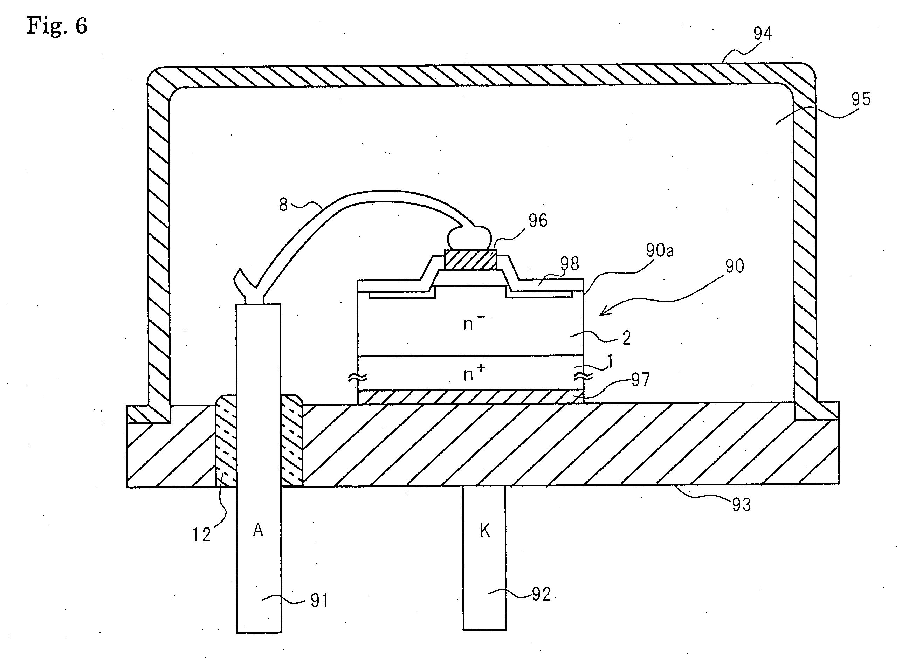

FIG. 6 is a sectional view showing a package in the case that a SiC diode device being convenient to be incorporated in various apparatuses is configured by using a conventional SiC diode element. In the figure, a SiC diode element 90 is mounted on the upper face of a support member 93 made of metal and having a cathode terminal 92 on the lower face thereof. The cathode electrode 97 of the SiC diode element 90 makes contact with the upper face of the support member 93. The support member 93 is further provided with an anode terminal 91. The anode terminal 91 passes through the support member 93 while being insulated via an insulator 12. The anode terminal 91 is connected to the anode electrode 96 of the SiC diode element 90 by using a lead wire 8. A cap 94 made of metal is provided on the upper face of the support member 93 so as to cover the diode element 90. The space 95 containing the diode element 90 is hermetically sealed with the cap 94. The space 95 is filled with sulfur hexafluoride gas. The reason why the space is filled with sulfur hexafluoride gas is as described below. That is to say, since the creepage distance between the anode electrode 96 and an exposed side face 90a not covered with a passivation film 98 is short, the reverse withstand voltage therebetween cannot be raised. The inside of the package is filled with sulfur hexafluoride gas serving as an insulating gas to raise the reverse withstand voltage. If an inert gas, such as nitrogen gas, or a noble gas, such as argon, is used as an insulating gas, discharge occurs in the gas when a high voltage is applied because the maximum dielectric breakdown strength is low, whereby the SiC diode element 90 itself and the passivation film 98 made of, for example, silicon carbide, are destructed. Under the present circumstances, the space is filled with sulfur hexafluoride that is very stable even at a high temperature of approximately 150 to 200°C to have higher withstand voltage, whereby dielectric breakdown due to discharge is prevented.
Patent Document 1: Japanese Patent No.3395456
Patent Document 2: Japanese Patent No.3409507
Nonpatent Document 1: "Proceedings of 2001 International Symposium on Power Semiconductor or Devices & IC's," pp. 27 to 30, Collected Papers of 2001 International Society
Nonpatent Document 2: "Power Device, Power IC Handbook," p. 289, FIG. 9.102: edited by the Institute of Electric Engineers of Japan, issued by CORONA PUBLISHING CO., LTD. (Date of issue: July 30, 1996)

### DISCLOSURE OF THE INVENTION

### PROBLEM TO BE SOLVED BY THE INVENTION

At present, sulfur hexafluoride gas has the best insulation performance as an insulating gas; however, since it includes fluorine, the use of the gas should be avoided from the viewpoint of prevention of global warming. In particular, in order that high insulation performance is obtained, the pressure of the sulfur hexafluoride gas to be filled inside a semiconductor device is required to be set at approximately 2 atms at the room temperature. However, if the temperature of the semiconductor device rises during usage, the pressure of the sulfur hexafluoride being filled therein rises to 2 atms or more. Hence, if the package of the semiconductor device is not robust considerably, there is a danger of explosion or gas leakage. Wide-gap semiconductor devices are sometimes operated at a high temperature of nearly 500°C. In such a case, the gas expands thermally, the pressure of the gas rises considerably; as a result, the danger of explosion and gas leakage further increases, and there causes a problem that the sulfur hexafluoride gas is thermally decomposed and the withstand voltage lowers.

In order that the high insulation performance of semiconductor devices is maintained by using substances other than sulfur hexafluoride gas, it is known that the semiconductor elements thereof are thickly covered with insulating materials. As conventional materials having excellent insulation performance, silicon rubber and epoxy resin are known (refer to Nonpatent Document 2). Silicon rubber is a synthetic polymer compound containing polymethylphenylsiloxane having the linear structure of siloxane bonds (Si-O-Si bonds). When the whole of a semiconductor element (semiconductor chip) is covered with coverings formed of these synthetic polymer compounds, the device can maintain high insulation performance and the withstand voltage can be raised.

Although the heat resistance of the above-mentioned polymethylphenylsiloxane is not so high, when it is used for a semiconductor device that is used at a junction temperature of 150°C or less as in the case of a Si power semiconductor element, high withstand voltage can be attained. However, when it is used at a high temperature of 200°C or more as in the case of a semiconductor element comprising SiC serving as a wide-gap semiconductor material, heat resistance is not sufficient. The covering made of polymethylphenylsiloxane has low flexibility when the temperature of the SiC semiconductor element becomes 200°C or more during usage, and the covering is vitrified at 230°C or more in the air and becomes completely hard. Hence, when the temperature of the SiC semiconductor element returns to the room temperature, numerous cracks are generated inside the covering made of the polymethylphenylsiloxane. In addition, if an element covered with polymethylphenylsiloxane is operated in an inert gas, such as sulfur hexafluoride gas, at high temperature for a long time, weight reduction occurs, and voids and cracks are generated near the surface of the element. This is presumed that the methyl groups and the phenyl groups in the side chains of the polymethylphenylsiloxane are decomposed and evaporate. If such voids and cracks are generated, the surface protection of the element becomes incomplete, and leak current increases. Furthermore, the passivation film of the element is sometimes damaged when cracks are generated; as a result, the leak current increases significantly, and the semiconductor element is sometimes destructed eventually. As described above, polymethylphenylsiloxane has disadvantages of being low in heat resistance, incapable of withstanding high electric fields at high temperature and low in withstand voltage.

Similarly, epoxy resin is low in flexibility at high temperature, and it is vitrified at 200°C or more and becomes hard. Hence, when the temperature of the SiC semiconductor element returns from its high temperature state during energization to its room temperature state during OFF time, numerous cracks are generated inside the epoxy resin, and the epoxy resin cannot withstand high electric fields, and the withstand voltage becomes low.

In addition, since silicon rubber and epoxy resin are low in heat conductivity, if a semiconductor element is covered with these, the heat generated from the semiconductor element cannot be dissipated sufficiently. Since the heat is mostly dissipated only through the support member 93, if the semiconductor element becomes heated to high temperature, it is sometimes destructed thermally. In particular, when the distance between the junction of the semiconductor element and the support member 93 is considerably larger than the distance between the junction and the surface of the element making contact with the resin or the rubber, the dissipation of the heat generated from the semiconductor element deteriorates, and the temperature of the element rises significantly. When the heat conductivity and heat capacity of the support member are small, the heat dissipation via the support member also deteriorates, resulting in serious problems.

The present invention is intended to provide a highly heat-resistant synthetic polymer compound suited for covering semiconductor elements and the like and to provide semiconductor devices having high heat resistance and high withstand voltage.

### MEANS FOR SOLVING PROBLEM

(1) A highly heat-resistant synthetic polymer compound according to the present invention is formed by connecting at least one kind of first organosilicon polymer and at least one kind of second organosilicon polymer with siloxane bonds (Si-O-Si bonds) to prepare a third organosilicon polymer and by connecting multiple third organosilicon polymers with covalent bonds generated by an addition reaction, thereby having a three-dimensional stereostructure. In addition, the first organosilicon polymer has a crosslinked structure connected with siloxane bonds, the second organosilicon polymer has a linear connection structure connected with siloxane bonds, and the third organosilicon polymer has a molecular weight of 20,000 to 800,000.

(2) A highly heat-resistant synthetic polymer compound according to another aspect of the present invention is formed by connecting at least one kind of first organosilicon polymer and at least one kind of second organosilicon polymer with siloxane bonds to prepare a third organosilicon polymer, by connecting multiple third organosilicon polymers with covalent bonds generated by an addition reaction, thereby having a three-dimensional stereostructure, and by containing insulating ceramic particles having high heat conductance. In addition, the first organosilicon polymer has a crosslinked structure connected with siloxane bonds, the second organosilicon polymer has a linear connection structure connected with siloxane bonds, and the third organosilicon polymer has a molecular weight of 20,000 to 800,000.

(3) A semiconductor device according to the present invention has a synthetic polymer compound for covering a semiconductor element and at least part of electrical connection portions for electrically connecting the semiconductor element to external apparatuses. The synthetic polymer compound is formed by connecting at least one kind of first organosilicon polymer and at least one kind of second organosilicon polymer with siloxane bonds to prepare a third organosilicon polymer and by connecting multiple third organosilicon polymers with covalent bonds generated by an addition reaction, thereby having a three-dimensional stereostructure. In addition, the first organosilicon polymer has a crosslinked structure connected with siloxane bonds, the second organosilicon polymer has a linear connection structure connected with siloxane bonds, and the third organosilicon polymer has a molecular weight of 20,000 to 800,000.

(4) A semiconductor device according to another aspect of the present invention has a synthetic polymer compound for covering a semiconductor element and at least part of electrical connection portions for electrically connecting the semiconductor element to external apparatuses. The synthetic polymer compound is formed by connecting at least one kind of first organosilicon polymer and at least one kind of second organosilicon polymer with siloxane bonds to prepare a third organosilicon polymer, and by connecting multiple third organosilicon polymers with covalent bonds generated by an addition reaction, thereby having a three-dimensional stereostructure, and by containing insulating ceramic particles having high heat conductivity at a volumetric filling factor of 15% or more. In addition, the first organosilicon polymer has a crosslinked structure connected with siloxane bonds, the second organosilicon polymer has a linear connection structure connected with siloxane bonds, and the third organosilicon polymer has a molecular weight of 20,000 to 800,000.

(5) A semiconductor device according to still another aspect of the present invention comprises at least one semiconductor element mounted on a heat conductive substrate, electrical connection portions for electrically connecting the semiconductor element to external apparatuses, a first synthetic polymer compound for covering the semiconductor element and at least part of the electrical connection portions, a package, configured so as to be combined with the substrate, for accommodating the semiconductor element and the electrical connection portions covered with the first synthetic polymer compound, a second synthetic polymer compound filled in the space inside the package, and external connection terminals connected to the electrical connection portions and extended to the outside of the package. In addition, the first synthetic polymer compound is formed by connecting at least one kind of first organosilicon polymer and at least one kind of second organosilicon polymer with siloxane bonds to prepare a third organosilicon polymer, by connecting multiple third organosilicon polymers with covalent bonds generated by an addition reaction, thereby having a three-dimensional stereostructure, and by containing insulating ceramic particles having high heat conductance. Furthermore, the first organosilicon polymer has a crosslinked structure connected with siloxane bonds, the second organosilicon polymer has a linear connection structure connected with siloxane bonds, and the third organosilicon polymer has a molecular weight of 20,000 to 800,000. Moreover, the second synthetic polymer compound is formed by connecting at least one kind of fourth organosilicon polymer and at least one kind of fifth organosilicon polymer with siloxane bonds to prepare a sixth organosilicon polymer, by connecting multiple sixth organosilicon polymers with covalent bonds generated by an addition reaction, thereby having a three-dimensional stereostructure, and by containing insulating ceramic particles having high heat conductance. Still further, the fourth organosilicon polymer has a crosslinked structure connected with siloxane bonds, the fifth organosilicon polymer has a linear connection structure connected with siloxane bonds, and the sixth organosilicon polymer has a molecular weight of 20,000 to 800,000.

### EFFECT OF THE INVENTION

In the above-mentioned item (1) of the present invention, the first organosilicon polymer is excellent in heat resistance but very low in flexibility after curing, thereby being difficult to be applied thickly and low in withstand voltage performance. On the other hand, the second organosilicon polymer is low in heat resistance, but high in flexibility-after curing, thereby being able to be applied thickly and high in withstand voltage performance. Furthermore, the first organosilicon polymer and the second organosilicon polymer are connected three-dimensionally. Hence, with the present invention, the excellent heat resistance of the first organosilicon polymer can be maintained while the flexibility of the second organosilicon polymer is not lost; as a result, it is possible to obtain the synthetic polymer compound satisfying the two characteristics of high heat resistance and high withstand voltage.

With the above-mentioned item (2) of the present invention, since the insulating ceramic particles having high heat conductance are mixed, high heat conductance can be attained without impairing withstand voltage performance. Herein, the fact that the heat conductance is high means that the heat conductivity is higher than that of epoxy resin or silicon rubber. The heat conductivity should be higher, as long as other performance levels are not impaired.

With the above-mentioned item (3) of the present invention, since the semiconductor element and the electrical connection portions are covered with the synthetic polymer compound satisfying the two characteristics of high heat resistance and high withstand voltage as described above, it is possible to obtain a semiconductor device having high heat resistance and high withstand voltage.

In the above-mentioned item (4) of the present invention, since the insulating ceramic particles having high heat conductance are mixed in the synthetic polymer compound, the heat conductance of the synthetic polymer compound is improved. Hence, the effect of dissipating the heat generated in the semiconductor element is high in the present invention. In addition, since the insulating ceramic particles also function as a filler, the shape retention of the synthetic polymer compound can be improved; it is thus possible to contribute to the improvement in withstand voltage performance. The shape retention is a property for maintaining a thickly raised shape. As described above, the synthetic polymer compound is excellent in heat dissipation and proper in shape retention. Hence, it is possible to obtain a semiconductor device having higher heat resistance and higher withstand voltage by covering the semiconductor element and the like with the synthetic polymer compound.

With the above-mentioned item (5) of the present invention, since the semiconductor element and the electrical connection portions are covered with the first synthetic polymer compound, the withstand voltage can be raised. In addition, since the package accommodating the semiconductor element and the electrical connection portions is filled with the second synthetic polymer compound, the semiconductor element and the electrical connection portions inside the package can be prevented from being damaged even when mechanical vibrations and impacts are applied from the outside. Furthermore, since the first synthetic polymer compound and the second synthetic polymer compound contain the insulating ceramic particles having high heat conductivity, they have excellent heat conductance and are high in the effect of conducting the heat generated from the semiconductor element to the package and then dissipating the heat to the outside.

In addition, in the present invention, the upper face and the side faces of the semiconductor element are covered with the synthetic polymer compound. The synthetic polymer compound is formed by connecting at least one kind of first organosilicon polymer and at least one kind of second organosilicon polymer with siloxane bonds to prepare a third organosilicon polymer, by connecting multiple third organosilicon polymers with covalent bonds generated by an addition reaction, thereby having a three-dimensional stereostructure, and by containing insulating ceramic particles having high heat conductivity. In addition, the first organosilicon polymer has a crosslinked structure connected with siloxane bonds, the second organosilicon polymer has a linear connection structure connected with siloxane bonds, and the third organosilicon polymer has a molecular weight of 20,000 to 800,000. Furthermore, the molecular weight of the second organosilicon polymer is larger than the molecular weight of the first organosilicon polymer.

Since the synthetic polymer compound has appropriate viscosity and high flexibility after curing, the compound can be formed into a domed shape thickly on the semiconductor element. As a result, the semiconductor device has high heat resistance and high withstand voltage performance. Since the synthetic polymer compound contains the insulating ceramic particles having high heat conductivity, the compound is excellent in heat conductance and high in the effect of dissipating the heat generated from the semiconductor element. Since the heat dissipation of the synthetic polymer compound is excellent, the heat generated from the inside of the semiconductor element can be dissipated not only from the support member side of the semiconductor element but also from the synthetic polymer compound side serving as the covering. Hence, excessive rise in the temperature of the element can be suppressed, whereby the performance of the element, such as operation speed, and thermal destruction of the element can be prevented. In addition, since the insulating ceramic particles also function as a filler, the compound can be formed into a domed shape raised so as to be thicker, and the shape retention for retaining the shape can be improved; it is thus possible to contribute to the improvement in withstand voltage performance. Therefore, it is possible to obtain a semiconductor device being excellent in heat dissipation and proper in shape retention and having higher heat resistance and higher withstand voltage performance by covering the semiconductor element with the synthetic polymer compound in which the insulating ceramic particles are mixed.

When stacking faults are present inside wide-gap semiconductors, such as SiC, there occurs a degradation phenomenon wherein the ON voltage during energization increases, thereby causing a problem wherein the ON voltage during energization increases as the temperature of the element becomes higher. Since the insulating ceramic particles are mixed in the synthetic polymer compound according to the present invention, the effect of dissipating the heat generated from the semiconductor element is high. Hence, the temperature rise of the element can be suppressed, the increase of the ON voltage can also be suppressed, and high reliability can be attained.

The synthetic polymer compound described above has very high affinity for wide-gap semiconductors and also has very high affinity for inorganic films made of silicon dioxide, silicon nitride or the like and being used as passivation films. Hence, the synthetic polymer compound firmly attaches to the surface of semiconductor elements, whereby the compound can maintain the high moisture resistance of semiconductor devices and can also maintain the high heat conductance thereof. Therefore, particularly high reliability and high withstand voltage performance can be attained when the semiconductor devices are operated at high temperature.

### BRIEF DESCRIPTION OF THE DRAWINGS

FIG. 1 is a sectional view showing a SiC pn diode device according to a first embodiment of the present invention;
FIG. 2 is a sectional view showing a SiC-GTO thyristor device according to a second embodiment of the present invention;
FIG. 3 is a sectional view showing the SiC-GTO thyristor element according to the second embodiment of the present, cross-sectioned along a plane perpendicular to the face of the paper on which FIG. 2 is shown;
FIG. 4 is a sectional view showing an optically-coupled wide-gap semiconductor device according to a third embodiment of the present invention;
FIG. 5 is a sectional view showing a SiC-GTO module according to a fourth embodiment of the present invention; and
FIG. 6 is a sectional view showing the conventional SiC diode device.

### EXPLANATIONS OF REFERENCE NUMERALS

- 8, 34, 36, 61, 63, 64, 73, 76: lead wire
- 9, 35, 67: anode terminal
- 10, 38, 67: support member
- 11, 39, 77: cathode terminal
- 13: SiC pn diode element
- 16,42,81,130,131: covering
- 20: GTO thyristor element
- 37: gate terminal
- 51: GaN npn bipolar transistor
- 52: SiC photodiode
- 62: base terminal
- 65: emitter terminal
- 68: collector terminal
- 101: copper substrate
- 102: frame
- 105: cover
- 165: filling material

### BEST MODES FOR CARRYING OUT THE INVENTION

The best modes of a highly heat-resistant synthetic polymer compound according to the present invention and high withstand voltage semiconductor devices according to the present invention covered with the highly heat-resistant synthetic polymer compound will be described below.

The novel synthetic polymer compound according to the present invention contains at least one kind of first organosilicon polymer and at least one kind of second organosilicon polymer. The first organosilicon polymer has a crosslinked structure connected with siloxane bonds and is selected from the group consisting of polyphenylsilsesquioxane, polymethylsilsesquioxane, polymethylphenylsilsesquioxane, polyethylsilsesquioxane, and polypropylsilsesquioxane. The second organosilicon polymer has a linear connection structure connected with siloxane bonds and is selected from the group consisting of polydimethylsiloxane, polydiethylsiloxane, polydiphenylsiloxane, and polymethylphenylsiloxane. In addition, the first organosilicon polymer and the second organosilicon polymer are connected linearly with siloxane bonds, thereby forming a large third organosilicon polymer. Furthermore, multiple third organosilicon polymers are connected three-dimensionally with covalent bonds generated by an addition reaction, and a synthetic polymer compound having a three-dimensional stereostructure is formed.

Moreover, the synthetic polymer compound according to the present invention contains insulating ceramic particles having high heat conductivity. The insulating ceramic having high heat conductivity is at least one kind selected from the group consisting of aluminum nitride (expressed as AIN), beryllium oxide (expressed as BeO), alumina (expressed as Al₂O₃) and polycrystalline SiC.

The synthetic polymer compound according to the present invention is further preferable that, for example, the first organosilicon polymer and the second organosilicon polymer are connected linearly with siloxane bonds to form the large third organosilicon polymer having a weight-average molecular weight (hereafter, simply referred to as molecular weight) of 20,000 to 800,000, and that multiple third organosilicon polymers are connected with alkylene groups.

The first organosilicon polymer having a crosslinked structure connected with siloxane bonds is excellent in heat resistance but is large in viscosity, thereby being very low in flexibility after curing; hence, thick coating is difficult and withstand voltage is low. However, with the present invention, since the first organosilicon polymer and the second organosilicon polymer having a linear connection structure connected with siloxane bonds are connected alternately and linearly, it is possible to obtain a synthetic polymer compound satisfying the two characteristics of high heat resistance and high withstand voltage without losing the flexibility provided for the second organosilicon polymer while the excellent heat resistance of the first organosilicon polymer is maintained. In order that the heat resistance is raised further, the molecular weight of the first organosilicon polymer should be made larger; in that case, however, the viscosity becomes higher, and the flexibility after curing becomes lower. Furthermore, in order that the flexibility is raised, the molecular weight of the second organosilicon polymer should be made larger; in that case, however, the heat resistance becomes lower. The molecular weight of the first organosilicon polymer is preferably 200 to 200,000, and further preferably 200 to 70,000. The molecular weight of the second organosilicon polymer is preferably 5,000 to 200,000. It is preferable that the molecular weight of the first organosilicon polymer should be smaller than the molecular weight of the second organosilicon polymer.

In addition, it is preferable that the insulating ceramic particles having high heat conductivity and contained in the synthetic polymer compound according to the present invention should have a shape being as close to a sphere as possible and having fewer sharp-pointed end portions to avoid local concentration of electric fields and to attain high withstand voltage. Furthermore, it is preferable that the mixture factor (hereafter referred to as filling factor) of the insulating ceramic particles in the synthetic polymer compound should be set in consideration of desired heat conductivity. If the filling factor is small, the effect of increasing the heat conductivity is low; hence, it is preferable that the volumetric filling factor of the insulating ceramic particles in the synthetic polymer compound should be in the range of 15 to 85%vol. If the particle diameter is excessively large, the volumetric filling factor lowers. On the other hand, if the particle diameter is excessively small, the particles are likely to coagulate with one another, and the volumetric filling factor also lowers. For this reason, it is preferable that the particle diameter should be in the range of 0.01 to 50 µm. To increase the volumetric filling factor to 50% or more, it is preferable that particles having different particle diameters should be blended, and the ratio of the particle diameters in that case is preferably in the range of 1:1/10 to 1:1/200. Since the insulating ceramic particles being used for the filling do not affect the connection of the synthetic polymer compound, the heat resistance is not impaired; on the other hand, the particles affects the viscosity; however, practical problems are not caused, provided that the filling factor and the shape of the particles are within the above-mentioned ranges.

Since the most connections in the synthetic polymer compound according to the present invention have siloxane bonds, the compound has high insulation performance, i.e., high withstand voltage performance as described above. In addition, the synthetic polymer compound has very high affinity for an inorganic film made of silicon dioxide, silicon nitride or the like and serving as the passivation film of a wide-gap semiconductor element, thereby firmly attaching to the surface of the passivation film. Furthermore, it is found that the synthetic polymer compound also has very high affinity for wide-gap semiconductors themselves, such as Sic and GaN, and has excellent adhesiveness of firmly attaching to the surfaces of the semiconductor elements.

Since a semiconductor device having a wide-gap semiconductor element covered with the synthetic polymer compound having the excellent adhesiveness described above has high moisture resistance, it is possible to attain a highly reliable semiconductor device. The synthetic polymer compound has very high affinity for wide-gap semiconductors, such as Sic and GaN. Hence, for example, even if a wide-gap semiconductor is exposed because defects, such as pin holes, are present in the passivation film, the synthetic polymer compound serves as a passivation film for directly protecting the surface of the wide-gap semiconductor element, whereby high reliability can be attained.

The second organosilicon polymer has almost the same molecular structure as that of Si rubber. Hence, as proven conventionally in Si rubber, the synthetic polymer compound according to the present invention has excellent adhesiveness with inorganic substances for passivation films, various metals (copper, aluminum, stainless steel, etc.), various resins (epoxy resin, acrylic resin, phenol resin, etc.), various kinds of glass, etc. and attaches to these firmly. For this reason, the surface protection film formed of the synthetic polymer compound attaches closely and firmly to the metal electrodes, electric connection portions, support member, etc. of a semiconductor element with no clearances, whereby high moisture resistance can be attained. Hence, the present invention can attain a semiconductor device having high reliability and high withstand voltage performance.

Since most of the synthetic polymer compound according to the present invention has a siloxane structure, the compound is high in translucency to ultraviolet light and visible light. Hence, it is possible to visually observe the state of the synthetic polymer compound applied to semiconductor elements and electrical connection portions. For example, it is possible to efficiently carry out application work while visually checking that air bubbles, voids and the like are not present.

In wide-gap light-emitting power semiconductor devices and wide-gap optically-coupled power semiconductor devices comprising the synthetic polymer compound according to the present invention, both high-temperature high-withstand voltage performance capable of protecting semiconductor elements even at high temperature and highly efficient optical coupling performance allowing light to transmit sufficiently even at high temperature can be satisfied simultaneously.

The insulating ceramic particles filled in the compound slightly affect the above-mentioned translucency and the adhesiveness with materials constituting semiconductor devices, but hardly cause any practical problems, provided that the filling factor and the particle diameter are within the above-mentioned ranges.

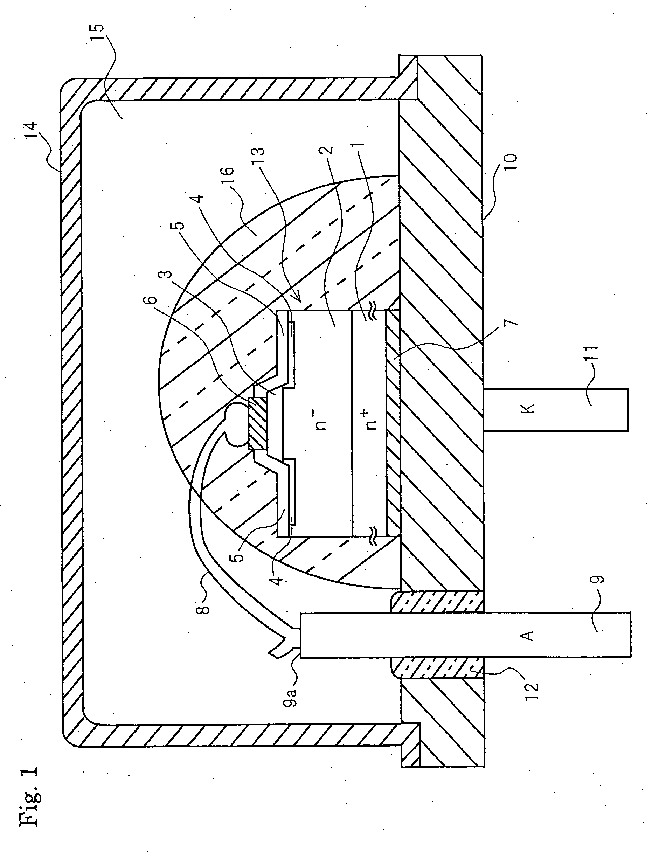

Preferred embodiments according to the present invention will be described below referred to FIG. 1 to FIG. 5. In order that the configurations thereof can be understood easily in the respective figures, the dimensions of the respective components shown in the figures do not correspond to the actual dimensions. In each embodiment, "a semiconductor device" is referred to as a device in which a semiconductor element is accommodated in a package and the electrodes of the semiconductor element are connected to electrode terminals that are extended to the outside.

### FIRST EMBODIMENT

FIG. 1 is a sectional view showing a highly heat-resistant and high withstand voltage semiconductor device according to a first embodiment of the present invention. In the semiconductor device according to this embodiment, a high withstand voltage SIC (silicon carbide) pn diode element 13 having a withstand voltage of 8 kV is accommodated in a package 14, and the SIC pn diode element 13 is covered with a covering 16 formed of the highly heat-resistant and highly heat dissipating synthetic polymer compound according to the present invention.

The SiC pn diode element 13 has a configuration described below. On the upper face of an n-type SiC cathode region 1 having high impurity concentration and a thickness of approximately 300 µm, an n-type SiC drift layer 2 having low impurity concentration and a thickness of approximately 90 µm is formed. On the lower face of the cathode region 1, a cathode metal electrode 7 is formed. In the central region of the drift layer 2, a p-type SiC anode region 3 constituting the main junction is formed. On the anode region 3, an anode electrode 6 made of metal is formed. Around the anode region 3, a p-type field relaxation region 4 is formed. On the upper face of the SiC pn diode element 13 including the anode region 3 and the field relaxation region 4, a surface protection film 5 having a three-layer structure comprising a silicon dioxide layer, a silicon nitride layer and a silicon dioxide layer overlaid in this order is formed. The anode electrode 6 is connected to the upper end 9a of an anode terminal 9 by using a gold lead wire 8 and serving as an electrical connection portion. In FIG. 1, the lead wire 8 is shown as only one wire. As the lead wire 8, multiple wires may be connected in parallel depending on the value of the current flowing through the lead wire 8.

A cathode electrode 7 is installed on a support member 10 made of metal so as to have electrical connection therebetween. To the support member 10, a cathode terminal 11 is connected. The anode terminal 9 and the cathode terminal 11 are connected to the wiring of external apparatuses or the like. The anode terminal 9 is firmly secured to the support member 10 so as to be insulated via an insulating glass tube 12 having a high melting point. On the support member 10, a cap 14 made of metal is provided so as to cover the SiC pn diode element 13, thereby hermetically sealing a space 15 containing the SiC pn diode element 13. A covering 16 formed of the synthetic polymer compound according to the present invention is provided so as to cover the SiC pn diode element 13 and part of the lead wire 8. The covering 16 is formed of a transparent synthetic polymer compound containing polyphenylsilsesquioxane as a first organosilicon polymer and polydimethylsiloxane as a second organosilicon polymer. In this synthetic polymer compound, particles of aluminum nitride (AIN) being used as an insulating ceramic material are mixed. The space 15 is filled with nitrogen gas.

An example of a method for producing the SiC pn diode semiconductor device according to this embodiment will be described below.

As shown in FIG. 1, first, the SiC pn diode element 13 produced in advance is soldered to a predetermined position on the upper face of the support member 10 by using high-temperature solder containing gold-silicon. Next, both ends of multiple gold lead wires 8 having a diameter of 80 µm are respectively connected to the anode electrode 6 and the upper end 9a of the anode terminal 9 by using a lead bonding apparatus.

Then, the synthetic polymer compound mixed with the AIN particles is applied so as to be formed into a mountain-like shape and to cover the whole face of the SiC pn diode element 13 and the vicinity of the connection portion between the lead wire 8 and the anode electrode 6, thereby forming the covering 16. As a method for the application, a method for extruding a predetermined amount of the synthetic polymer compound from a nozzle having a predetermined diameter is suited. When the synthetic polymer compound is maintained at a temperature of approximately 200°C for a predetermined time after the application, the compound is cured while having some flexibility. The viscosity of the synthetic polymer compound is adjusted properly by adjusting the molecular weight of the synthetic polymer compound in advance, whereby the compound can be applied so as to be formed into a domed-like raised shape as in the covering 16 shown in FIG. 1; hence, the SiC pn diode element 13 can be wholly covered with the synthetic polymer compound at a thickness of 300 µm or more without leaving any clearance. In this embodiment, the thickest portion of the covering 16 was approximately 1.2 mm. If the viscosity of the synthetic polymer compound is too high, it is difficult to form the compound into the desired domed shape shown in FIG. 1, and when the compound is applied, clearances are formed sometimes between the SiC pn diode element 13 and the covering 16. On the other hand, if the viscosity of the synthetic polymer compound is too low, the compound is not raised to a domed shape, and the thickness of the covering 16 cannot be set to the desired thickness of 300 µm or more.

In order that the synthetic polymer compound has the above-mentioned appropriate viscosity, polyphenylsilsesquioxane having a molecular weight of approximately 15,000 is used as a first organosilicon polymer, polydimethylsiloxane having a molecular weight of approximately 90,000 is used as a second organosilicon polymer in this embodiment, and the first organosilicon polymer and the second organosilicon polymer are connected alternately and linearly with siloxane bonds, thereby forming a large third organosilicon polymer having a molecular weight of approximately 320,000. Furthermore, multiple third organosilicon polymers are connected via alkylene groups generated by an addition reaction, thereby forming a synthetic polymer compound having a three-dimensional stereostructure.

In addition, insulating ceramic particles are mixed in this synthetic polymer compound to provide high heat conductance, i.e., high heat conductivity. More specifically, AIN particles having a particle diameter of approximately 2 µm are mixed in the synthetic polymer compound at a volumetric filling factor of approximately 45%vol. As a result, it was possible to attain a high heat conductivity of approximately 4.7 W/mK without impairing the withstand voltage performance. If the volumetric filling factor is raised, the viscosity becomes high; hence, it is desirable that the volumetric filling factor should be set in the range of 20 to 80%vol in consideration of the desired heat conductivity and the desired viscosity.

The SiC pn diode element 13 is covered with the synthetic polymer compound, the synthetic polymer compound is thermally cured, the metal cap 14 is welded to the support member 10 in nitrogen atmosphere so as to be mounted thereon, and the inner space 15 is filled with nitrogen gas; as a result, a SiC pn diode is completed.

A voltage (reverse voltage) was applied across the anode terminal 9 and the cathode terminal 11 of the SiC pn diode element 13 according to this embodiment so that the potential of the cathode terminal 11 became higher, and a reverse withstand voltage of approximately 8.5 kV was measured. The above-mentioned reverse withstand voltage was able to be maintained even at a high temperature of 350°C at which Si semiconductor devices become inoperative. When a current was passed through the SiC pn diode element 13 according to this embodiment at a current density of 250 A/cm² at a high temperature atmosphere of 250°C, the forward voltage thereof was 4.31 V. Furthermore, the leak current density at the time when a reverse voltage of 8 kV was applied was 3 × 10⁻⁵ A/cm² or less, and the reverse recovery time serving as the guideline of operation speed was approximately 45 nsec or less. The forward voltage increased approximately 4%, and the leak current density and the reverse recovery time decreased approximately 10% in comparison with the case of the synthetic polymer compound not mixed with the AIN particles. This is presumed that the heat conductivity of the synthetic polymer compound was increased by the AIN particles mixed in the synthetic polymer compound, and that the heat of the SiC pn diode element 13 was properly dissipated to the inner space 15 via the synthetic polymer compound, whereby the increase in the temperature of the SiC pn diode element 13 was suppressed. Although it is impossible to directly measure the temperature of the SiC pn diode element 13, it was possible to estimate the decrease in the temperature of the SiC pn diode element 13 on the basis of the increase in the forward voltage and the decreases in the leak current density and the reverse recovery time.

In these conditions, a continuous energization test was conducted for 500 hours. Although it was presumed that the junction temperature of the element was 330°C or more, no cracks or deformations did not occur in the covering 16 after the test. In addition, deterioration in transparency due to white turbidity or the like did not occur. In view of this, it is presumed that excessive rise in the temperature of the element was suppressed because of the improvement in the heat dissipation due to the AIN particles mixed in the synthetic polymer compound. After the continuous energization test of 500 hours, a reverse voltage of 8 kV was applied in a high temperature atmosphere of 300°C, and the leak current was measured; the current density was 4 × 10⁻⁵ A/cm², this value being not much different from the value obtained before the energization test. The forward voltage during energization was 4.33 V, there being almost no change before and after the energization test. After the various tests described above, the semiconductor device was disassembled and observed visually. As a result, it was verified that the covering 16 formed of the synthetic polymer compound containing polyphenylsilsesquioxane as the first organosilicon polymer and polydimethylsiloxane as the second organosilicon polymer firmly attaches not only onto the surface protection film 5 on the field relaxation region 4 of the SiC pn diode element 13 but also to the SiC layer exposed on the side faces of the SiC pn diode element 13.

With the first embodiment of the present invention, the circumference of the SiC pn diode element 13 is covered with the synthetic polymer compound containing the first organosilicon polymer and the second organosilicon polymer at a predetermined ratio therebetween and further containing the insulating ceramic particles; hence, high insulation performance equivalent to that obtained when the SiC pn diode element 13 is placed in an atmosphere of sulfur hexafluoride gas can be attained at high temperature. In other words, it is possible to attain a SiC pn diode having high heat resistance and high insulation performance without using sulfur hexafluoride gas that adversely affects global warming.

### SECOND EMBODIMENT

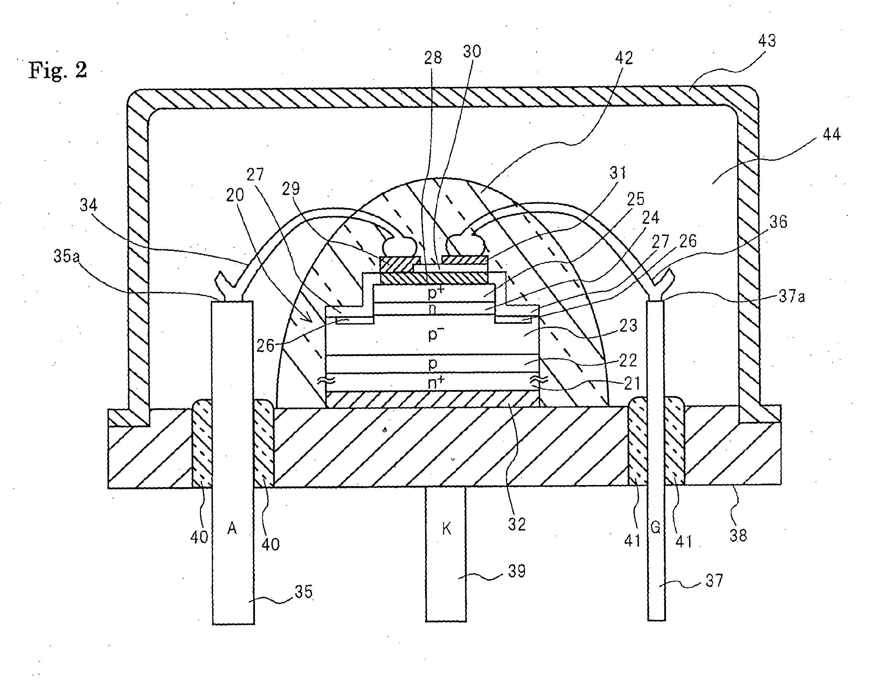

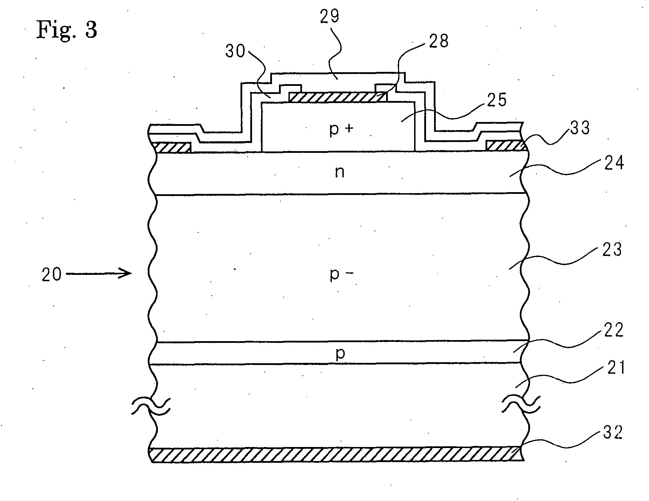

A semiconductor device according to a second embodiment of the present invention is a SiC-GTO thyristor (Gate Turn Off thyristor) having a withstand voltage of 5 kV. FIG. 2 is a sectional view thereof. FIG. 3 is a sectional view showing one cell of a GTO thyristor element 20, cross-sectioned along a plane perpendicular to the face of the paper on which FIG. 2 is shown. In an actual element, multiple cells, one of which is shown in FIG. 3, are connected in the left-right direction of the figure. In FIGS. 2 and 3, on the upper face of an n-type SiC cathode region 21 having high impurity concentration and a thickness of approximately 320 µm, a p-type SiC buffer layer 22 having a thickness of approximately 3 µm is provided. On the lower face of the cathode region 21, a cathode electrode 32 is provided. On the buffer layer 22, a p-type SiC drift layer 23 having low impurity concentration and a thickness of approximately 60 µm is provided. At the central portion of the drift layer 23, an n-type base region 24 and a p-type anode region 25, having a thickness of approximately 2 µm, are formed in this order. Around the n-type base region 24, an n-type field relaxation region 26 is formed. On the surface of the GTO thyristor element 20, a surface protection film 27 having a three-layer structure comprising a silicon dioxide layer, a silicon nitride layer and a silicon dioxide layer is formed. On the p-type anode region 25, an anode electrode 28 is formed. On the left region of the anode electrode 28, a second-layer anode electrode 29 is formed, and on the right region, a gate electrode 31 is formed via an insulation film 30. As shown in FIG. 3, a first-layer gate electrode 33 is formed on the n-type base region 24, and the gate electrode 33 is connected to a gate terminal 31 via a connection portion (not shown).

The anode electrode 29 is connected to the upper end 35a of an anode terminal 35 by using a gold lead wire 34. The gate electrode 31 is connected to the upper end 37a of a gate terminal 37 by using a gold lead wire 36. The lead wires 34 and 36, the anode terminal 35 and the gate terminal 37 are electrical connection portions. The cathode electrode 32 is mounted on a support member 38 made of metal and having a cathode terminal 39. The anode terminal 35 and the gate terminal 37 pass through the support member 38 and are firmly secured thereto while being insulated from the support member 38 via insulating glass tubes 40 and 41 having a high melting point, respectively.

The synthetic polymer compound is applied at a thickness of 250 µm or more so as to cover the whole face of the GTO thyristor element 20 and the vicinities of the connection portions between the lead wires 34 and 36 and the GTO thyristor element 20, thereby forming a covering 42. If the viscosity of the synthetic polymer compound is too high, it is difficult to form the compound into the desired domed shape as in the case of the embodiment, and when the compound is applied, clearances are formed sometimes between the SiC-GTO thyristor element 20 and the covering 42. On the other hand, if the viscosity is too low, the compound is not raised so as to have a domed shape, and the thickness of the covering 42 cannot be set to the desired thickness of 250 µm or more. In order that the compound has appropriate viscosity to be formed into a domed shape, polymethylphenylsilsesquioxane having a molecular weight of approximately 3,500 is used as a first organosilicon polymer, polymethylphenylsiloxane having a molecular weight of approximately 10,000 is used as a second organosilicon polymer in this embodiment, and the first organosilicon polymer and the second organosilicon polymer are connected alternately and linearly with siloxane bonds, thereby forming a large third organosilicon polymer having a molecular weight of approximately 40,000. Furthermore, multiple third organosilicon polymers are connected via alkylene groups generated by an addition reaction, thereby forming a synthetic polymer compound having a three-dimensional stereostructure. In addition, insulating ceramic particles are mixed in this synthetic polymer compound to attain predetermined high heat conductivity. More specifically, AIN particles having a particle diameter of approximately 3 µm and AIN particles having a particle diameter of approximately 0.1 µm, at a volume ratio of 6:4, are mixed in the synthetic polymer compound so as to have a volumetric filling factor of approximately 49%vol. In the synthetic polymer compound configured as described above, a high heat conductivity of approximately 11 W/mK was attained without impairing the withstand voltage performance.

The GTO thyristor element 20 is covered with the synthetic polymer compound as described above, the synthetic polymer compound is cured, a metal cap 43 is welded to the support member 38 in nitrogen atmosphere so as to be mounted thereon. As a result, a SiC-GTO thyristor device, the inner space 44 of which is filled with nitrogen gas, is completed.

The GTO thyristor element 20 is soldered to the support member 38 by using high-temperature solder containing gold-silicon. The lead wires 34 and 36 are gold wires having a diameter of 80 µm and are installed between the anode electrode 29 and the anode electrode 35, and between the gate electrode 31 and the gate terminal 37, respectively, by using a lead bonding apparatus. In FIG. 2, each of the lead wires 34 and 36 is shown as one wire in FIG. 2. However, multiple wires may also be connected in parallel for each of the lead wires 34 and 36, depending on the value of the current flowing therethrough.

In the SiC-GTO thyristor device according to this embodiment, a voltage of 5 kV was applied in the forward direction so that the potential of the anode terminal 35 became higher than that of the cathode terminal 39, and the potential of the gate terminal 37 was made equal to that of the anode terminal 35; as a result, the OFF state in which no current flows was maintained, and a withstand voltage of 5 kV was obtained.

Next, in this OFF state, the potential of the gate terminal 37 is made lower than the potential of the anode terminal 35, and a gate current is passed from the anode terminal 35 to the gate terminal 37; as a result, the SiC-GTO thyristor device is set to the ON state, and a current is passed between the anode terminal 35 and the cathode terminal 39. Furthermore, when the potential of the gate terminal 37 is made higher than the potential of the anode terminal 35 in the ON state, the current flowing between the anode terminal 35 and the cathode terminal 39 is shifted to the current flowing between the gate terminal 37 and the cathode terminal 39, and the device becomes the OFF state. The voltage obtained at this time between the anode terminal 35 and the cathode terminal 39 is the reverse withstand voltage.

More specifically, when a negative voltage is applied to the cathode terminal 39 and when a voltage higher than the built-in voltage with reference to the potential of the anode terminal 35 is applied to the gate terminal 37, the SiC-GTO thyristor element 20 is set to the ON state. At this time, electrons are injected from the cathode region 22 into the drift layer 23, whereby conductivity modulation occurs, and the ON resistance decreases significantly. In the ON state of the SiC-GTO thyristor element 20, when the potential of the gate terminal 37 is raised higher than the potential of the anode terminal 35, part of the current flowing between the anode terminal 35 and the cathode terminal 39 is extracted from the gate terminal 37, whereby the GTO thyristor element 20 can be set to the OFF state.

The reverse withstand voltage of the SiC-GTO thyristor device according to this embodiment is approximately 5.8 kV, and the reverse withstand voltage can be maintained even at a high temperature atmosphere of 250°C; the leak current density in the case that the reverse voltage is 5 kV is 5 × 10⁻⁴ A/cm² or less, an excellent value. As described above, it was possible to verify that this embodiment has high heat resistance and high withstand voltage that were impossible with Si GTO thyristors.
Furthermore, first and second operation tests were carried out for the SiC-GTO thyristor device according to this embodiment, and it was verified that this embodiment has further effects.

In the first operation test, continuous operation of 250 hours was carried out in a high temperature atmosphere of 150°C, wherein a current was passed at a high current density of 210 A/cm² in the SiC-GTO thyristor element 20 according to this embodiment while the current was turned ON/OFF at a frequency of 2 kHz. However, matters causing particular problems in practice did not occur. It is presumed that the junction temperature of the SiC-GTO thyristor element 20 at this time is approximately 308°C. The conventional silicon GTO thyristors were inoperative at a junction temperature of 150°C or more Furthermore, it is difficult to produce 5 kV-class silicon GTO thyristors having a current density of 210 A/cm².

In the second operation test, continuous operation of 500 hours was carried out in a high temperature and high humidity atmosphere of 80°C and 85% RH while a current was passed at the above-mentioned current density. After the first and second operation tests described above, the SiC-GTO thyristor device was disassembled and examined. There occurred no deformations, cracks, white turbidity or the like in the covering 42 formed of the synthetic polymer compound.

The forward voltage of the SiC-GTO thyristor was 4.2 V immediately after the start of the above-mentioned first operation test. Generally speaking, when stacking faults are present inside wide-gap bipolar semiconductors, such as SiC-GTO thyristors, there occurs a degradation phenomenon wherein the forward voltage during energization increases, thereby causing a problem wherein the forward voltage during energization increases as the temperature of the element becomes higher. However, in this embodiment, since the effect of dissipating the heat generated in the semiconductor element is enhanced by mixing the insulating ceramic particles, the temperature rise of the element can be suppressed; as a result, the above-mentioned degradation phenomenon can be suppressed. More specifically, when the forward voltage was measured in the same conditions as those of the above-mentioned first operation test after the first and second operation tests, the increment was 0.3 V or less. The leak current density at the time when a reverse voltage of 5 kV was applied after the first and second operation tests was 6 × 10⁻⁴ A/cm² or less at a temperature of 250°C, this value indicating just a slight change. The turn-ON time was approximately 0.42 msec and the turn-OFF time was approximately 1.1. msec at the room temperature. These switching times were not changed significantly before and after the first and second operation tests described above. On the other hand, when the AIN particles were not mixed in the synthetic polymer compound, the forward voltage increased 1.5 V or more, and the turn-OFF time decreased approximately 12%.

The turn-ON time and the turn-OFF time of the SiC-GTO thyristor element 20 according to this embodiment are approximately one-twentieth of those of the conventional silicon GTO thyristors having a withstand voltage of 6 kV.

The attachment state of the covering 42, which is formed of the synthetic polymer compound according to this embodiment and applied to the GTO thyristor element 20, to the GTO thyristor element 20 or the like was examined. It was found that the covering 42 firmly attached to the surface protection film 27 on the field relaxation region 26 of the GTO thyristor element 20 and the exposed faces on the side faces of the SiC.

### THIRD EMBODIMENT

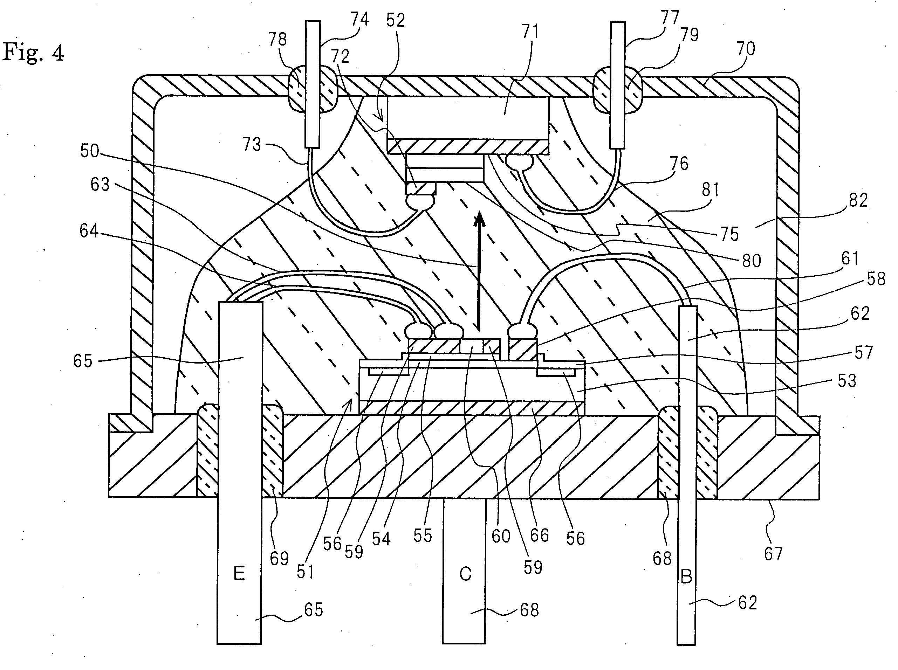

A semiconductor device according to a third embodiment of the present invention, i.e., an optically-coupled wide-gap power semiconductor device, will be described referring to FIG. 4 showing a cross-sectional view thereof. In this embodiment, a GaN (gallium nitride)-npn bipolar transistor 51 having a withstand voltage of 3 kV and a current capacity of 200 A is used as a power semiconductor element having a light-emitting function. A SiC photodiode 52 is used as a light-receiving element. The SiC photodiode 52 is accommodated inside the same package so as to be opposed to the GaN-npn bipolar transistor 51.

In the GaN-npn bipolar transistor 51 shown in FIG. 4, on the upper face of an n-type GaN collector region 53 having high impurity concentration and a thickness of approximately 300 µm, a p-type GaN p-base region 54 having a thickness of approximately 1.7 µm is formed, and an n-type emitter region 55 having high impurity concentration and a thickness of approximately 3 µm is formed thereon. On the lower face of the GaN collector region 53, a collector electrode 66 is provided. Inside the collector region 53 around the GaN base region 54, an n-type field relaxation region 56 is formed. On the right end portion of the GaN base region 54, a base electrode 58 made of metal is provided. On the n-type base region 55, an emitter electrode 59 made of metal and having a light emission window 60 is provided. On the GaN collector region 53 and the field relaxation region 56, a surface protection film 57 having a two-layer structure comprising a silicon nitride layer and a silicon dioxide layer is formed.

The base electrode 58 is connected to a base terminal 62 by using a gold lead wire 61. The emitter electrode 59 is connected to an emitter terminal 65 by using two gold lead wires 63 and 64. The collector electrode 66 is installed on a support member 67 made of metal and having a collector terminal 68.

In the SiC photodiode 52, its light-receiving portion 80 is bonded to the inner face of a cap 70 via an insulating plate 71 made of aluminum nitride or the like so as to be opposed to the light emission window 60 of the GaN-npn bipolar transistor 51 and to receive light 50. The anode electrode 72 of the SiC photodiode 52 is connected to an anode terminal 74 made of metal by using a gold lead wire 73. A cathode electrode 75 is connected to a cathode terminal 77 by using a gold lead wire 76. The anode terminal 74 and the cathode terminal 77 are respectively connected to external wires. The anode terminal 74 and the cathode terminal 77 are firmly secured in the through holes in the cap 70 via insulating glass tubes 78 and 79 having a high melting point.

A covering 81 formed of the synthetic polymer compound is provided so as to cover the GaN-npn bipolar transistor 51, the SiC photodiode 52, the lead wires 61, 63, 64, 73 and 76, and the end portion of the base terminal 62 and the end portion of the emitter terminal 65. The synthetic polymer compound contains polyethylsilsesquioxane as a first organosilicon polymer and polydimethylsiloxane as a second organosilicon polymer. The lead wires 61, 63, 64, 73 and 76, the emitter terminal 65, the base terminal 62, the collector terminal 68, the anode terminal 74 and the cathode terminal 77 are electrical connection portions. As each of the lead wires 61, 63, 64, 73 and 76, multiple wires may be connected in parallel depending on the value of the current flowing therethrough.

If the viscosity of the synthetic polymer compound is too high, it is difficult to form the covering 81 into such a desired shape as that of this embodiment, and clearances are formed sometimes between the GaN-npn bipolar transistor 51 and the covering 81. On the other hand, if the viscosity is too low, the lead wires in the SiC photodiode 52 and the GaN-npn bipolar transistor 51 are exposed extensively, and discharges occur sometimes between the lead wires, thereby lowering withstand voltage performance. In this embodiment, in order that the synthetic polymer compound has appropriate viscosity, polyethylsilsesquioxane having a molecular weight of approximately 1,500 is used as a first organosilicon polymer, polydimethylsiloxane having a molecular weight of approximately 55,000 is used as a second organosilicon polymer, and the first organosilicon polymer and the second organosilicon polymer are connected alternately and linearly with siloxane bonds, thereby forming a large third organosilicon polymer having a molecular weight of approximately 170,000. Furthermore, multiple third organosilicon polymers are connected via alkylene groups generated by an addition reaction, thereby forming a synthetic polymer compound having a three-dimensional stereostructure. Furthermore, the synthetic polymer compound is mixed with insulating ceramic particles so as to have high heat conductivity. More specifically, beryllium oxide (BeO) particles having a particle diameter of approximately 1.5 µm are mixed in the synthetic polymer compound so that a volumetric filling factor of approximately 47%vol is obtained. As a result, in this embodiment, it was possible to attain a high heat conductivity of approximately 6.5 W/mK without impairing the withstand voltage performance. Since BeO is nearly transparent and has excellent optical transmission, it does not impair the transmission of the light 50.

An example of a method for producing the optically-coupled wide-gap power semiconductor device according to the third embodiment will be described below.

The GaN-npn bipolar transistor 51 produced in advance is soldered to the predetermined position of the support member 67 by using gold-silicon high melting point solder. The emitter electrode 59 is connected to the emitter terminal 65 via the gold lead wires 63 and 64 having a diameter of 80 µm by using a lead bonding apparatus. The base electrode 58 is connected to the base terminal 62 by using the gold lead wire 61. The synthetic polymer compound before being cured, serving as the material of the covering 81, is thickly applied so as to cover the GaN-npn bipolar transistor 51.

The SiC photodiode 52 produced in advance is soldered to the inner face of the metal cap 70 via the insulating plate 71 made of aluminum nitride by using gold-silicon high melting point solder. Next, the anode electrode 72 is connected to the anode terminal 74 via the gold lead wire 73 having a diameter of 80 µm by using a lead bonding apparatus. In addition, the cathode electrode 75 is connected to the cathode terminal 77 by using the gold lead wire 76. Next, the synthetic polymer compound before being cured, serving as the material of the covering 81, is thickly applied so as to cover the SiC photodiode 52 and the vicinities of the connection portions between the lead wires 73 and 76 and the SiC photodiode 52. In the end, the metal cap 70 and the support 67 are assembled so that the light-receiving portion 80 of the SiC photodiode 52 is opposed to the light emission window 60 of the GaN-npn bipolar transistor 51 and so that the synthetic polymer compound portions with which the two are covered make contact with each other, and then welding is carried out in nitrogen atmosphere. Then, the device is heated to a predetermined temperature, and the covering 81 formed of the synthetic polymer compound is cured in a state of having a certain degree of flexibility, whereby the production is completed.

An example of the operation of the optically-coupled wide-gap power semiconductor device according to the third embodiment will be described below. First, the potential of the collector terminal 68 of the GaN-npn bipolar transistor 51 is made higher than the potential of the emitter terminal 65, whereby a forward-bias state is obtained. Then, the potential of the base terminal 62 is made equal to the potential of the emitter terminal 65. Hence, the OFF state wherein no current flows is maintained. Since the withstand voltage is 3 kV, it is possible to attain high withstand voltage. The potential of the anode terminal 74 of the SiC photodiode 52 is made lower than the potential of the cathode terminal 77, whereby a reverse-bias state is obtained.

ON/OFF driving is carried out as follows. First, the potential of the base terminal 62 is made higher than the potential of the emitter terminal 65, and a base current is passed from the base terminal 62 to the emitter terminal 65. Hence, electrons are injected from the emitter electrode 59, and the GaN-npn bipolar transistor 51 is set to the ON state; as a result, light 50 having a wavelength of approximately 387 to 565 nm is generated. This light 50 is received by the SiC photodiode 52, and a photoelectric current corresponding to the amount of the light flows between the anode terminal 74 and the cathode terminal 77.

If the potential of the base terminal 62 is made equal to or lower than the potential of the emitter terminal 65 when the GaN-npn bipolar transistor 51 is in the ON state, electron injection stops, the current flowing between the collector electrode 66 and the emitter electrode 59 is shut off, and light emission stops. Since no light is emitted, the SiC photodiode 52 has no photoelectric current and is set to the OFF state.

The withstand voltage of the GaN-npn bipolar transistor 51 according to this embodiment is approximately 3.5 kV; this withstand voltage was maintained even at a high temperature of 250°C. The leak current density thereof at 3 kV was 2 × 10⁻⁴ A/cm² or less, an excellent value. In addition, the insulation withstand voltage between the GaN-npn bipolar transistor 51 and the SiC photodiode 52 was 5 kV or more, and the leak current density at 5 kV was 1 × 10⁻⁵ A/cm² or less. Even after a continuous voltage application test of 1,000 hours was conducted at a temperature of 250°C, the increase in leak current was a minute value within the measurement error range. It was thus possible to pass a current having a high current density of 150 A/cm² although the device has a high withstand voltage of 3 kV or more. Furthermore, even after continuous energization of 500 hours in a high temperature atmosphere of 200°C, there occurred no deformations, cracks, white turbidity or the like in the covering 81 formed of the synthetic polymer compound. Moreover, even after energization of 200 hours in a high temperature and high humidity atmosphere of 80°C and 85% RH, there occurred no deformations, cracks, white turbidity or the like in the covering 81 formed of the synthetic polymer compound.

The forward voltage during energization at a temperature of 200°C and a current density of 150 A/cm² was 5.2 V, and the change before and after the test was a small value within the measurement error range. The leak current density was 2 × 10⁻⁴ A/cm² or less at 250°C when a reverse voltage of 3 kV was applied after the above-mentioned test, there being almost no change in comparison with the value before the test. The turn-ON time was 0.1 microsecond and the turn-OFF time was 0.13 microsecond, both being high in speed; these switching times were not changed before and after the test. This is presumed that the temperature rise of the element was suppressed owing to the improvement in heat dissipation due to the BeO particles mixed in the synthetic polymer compound and that deterioration was minimal. When the BeO particles were not mixed in the synthetic polymer compound, changes were found in forward voltage, leak current density and turn-OFF time.

When the covering 81 was broken and observed, it was found that the covering 81 according to this embodiment also firmly attached to the GaN exposed on the side faces of the GaN-npn bipolar transistor 51.

### FOURTH EMBODIMENT

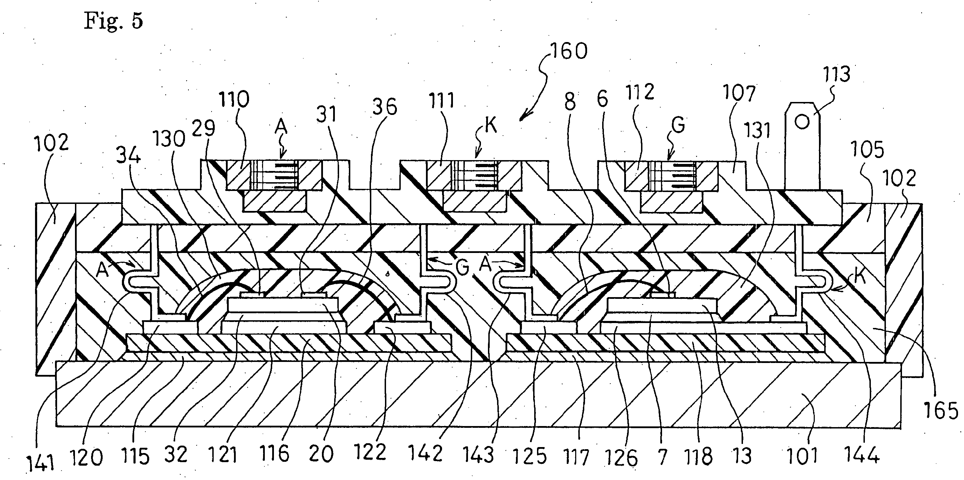

A highly heat-resistant semiconductor device according to a fourth embodiment of the present invention is a molded SiC-GTO module. In this device, a SiC-GTO element and a SiC diode element for one arm are incorporated in one package. FIG. 5 is a sectional view showing the main portions thereof. A SiC-GTO element 20 is the element having a withstand voltage of 5 kV, described in the second embodiment. A SiC diode element 13 has a structure similar to that of the element described in the first embodiment except that the withstand voltage thereof is designed to be 5 kV.

In FIG. 5, on the face of a nickel-plated copper substrate 101 having excellent heat conductance two insulating substrates 116 and 118 made of, for example, aluminum nitride, are bonded by using high-temperature solder portions 115 and 117, respectively, with a predetermined distance provided between the substrates.

On the insulating substrate 116, internal wires 120, 121 and 122 are formed by nickel-plated copper foil patterns. On the internal wire 121, the cathode electrode 32 of the SiC-GTO element 20 is bonded by using high-temperature solder. The anode electrode 29 of the SiC-GTO element 20 is connected to the internal wire 120 by using a lead wire 34 serving as an electrical connection portion. Furthermore, the gate electrode 31 of the SiC-GTO element 20 is connected to the internal wire 122 by using the lead wire 336 serving as an electrical connection portion.

On the insulating substrate 118, internal wires 125 and 126 are formed by copper foil patterns. On the internal wire 126, the cathode electrode 7 of the SiC pn diode element 13 is bonded by using high-temperature solder. The anode electrode 6 of the SiC pn diode element 13 is connected to the internal wire 125 by using a lead wire 8 serving as an electrical connection portion.

A first synthetic polymer compound is applied so as to cover the SiC-GTO element 20 and the lead wires 34 and 36 and to cover the most of the internal wires 120 and 122, thereby forming a covering 130. Similarly, the first synthetic polymer compound is applied so as to cover the SiC pn diode element 13 and the lead wire 8 and to cover the most of the internal wires 125 and 126, thereby forming a covering 131. The first synthetic polymer compound mainly contains polymethylphenylsilsesquioxane and polymethylphenylsiloxane as in the second embodiment. The molecular weight of polymethylphenylsilsesquioxane is approximately 5,000, and the molecular weight of polymethylphenylsiloxane is approximately 70,000. After these coverings 130 and 131 are cured, a frame 102 and a cover 105 are installed on the copper substrate 101, thereby forming a package (container or enclosure). The frame 102 is made of hard resin, such as epoxy resin, thereby being robust. Like the frame 102, the cover 105 is made of epoxy resin and robust, and is installed at the upper portion of the frame 102. The epoxy resin has high heat resistance since polyimidazole is used as a curing agent.

The frame 102 and the cover 105 are installed on the copper substrate 101 by using screws or an adhesive. The frame 102 and the cover 105 are formed of, for example, epoxy resin containing imidazole as a curing agent, and the glass transition temperature of the epoxy resin is approximately 325°C. The cover 105 is provided with a terminal block 107. The terminal block 107 is equipped with an anode terminal 110, a cathode terminal 111 and a gate terminal 112, each having a female thread, and further equipped with a preliminary terminal 113. The internal wire 120 connected to the anode electrode 29 of the SiC-GTO element 20 is connected to the anode terminal 110 via a connection wire 141 made of aluminum or the like and a conductor (not shown) passing between the cover 105 and the terminal block 107. The internal wire 121 connected to the cathode electrode 32 of the SiC-GTO element 20 is connected to the cathode terminal 111 via a conductor (not shown). The internal wire 122 connected to the gate electrode 31 of the SiC-GTO element 20 is connected to the gate terminal 112 via a connection wire 142 made of aluminum or the like and a conductor (not shown).

The internal wire 125 connected to the anode electrode 6 of the SiC pn diode element 13 is connected to the cathode terminal 111 via a connection wire 143 made of aluminum and a conductor (not shown). The internal wire 126 connected to the cathode electrode 7 of the SiC pn diode element 13 is connected to the anode terminal 110 via a connection wire 144 made of aluminum or the like and a conductor (not shown).

The space inside the package formed of the copper substrate 101, the frame 102 and the cover 105 is filled with a filling material 165 formed of a second synthetic polymer compound in gel form. As in the coverings 130 and 131, the filling material 165 is a synthetic polymer compound mainly containing polymethylpheriylsilsesquioxane and polymethylphenylsiloxane. The molecular weight of polymethylphenylsilsesquioxane is approximately 1,500, and the molecular weight of polymethylphenylsiloxane is approximately 55,000. Furthermore, the viscosity of the second synthetic polymer compound is set to a low value of approximately 15,000 cp. By comparison, the viscosity of the coverings 130 and 131 is 46,000 cp. As a result, the filling material 165 can be made very pliable after curing even at high temperature; hence, the filling material can have the function of a shock-absorbing agent for preventing the internal elements from being vibrated by mechanical vibrations and impacts applied to the module 160 from the outside. Furthermore, as insulating ceramic particles, AIN particles having various particle diameters are contained in each of the frame 102 and the cover 105 of the package formed of epoxy resin, the coverings130 and 131 formed of the first synthetic polymer compound and the filling material 165 formed of the second synthetic polymer compound. More specifically, AIN particles having a particle diameter of approximately 1 µm are mixed in the frame 102 and the cover 105 at a volumetric filling factor of approximately 46%vol. Furthermore, AIN superfine particles having a particle diameter of approximately 0.5 µm are mixed in the coverings 130 and 131 and the filling material 165 at a volumetric filling factor of approximately 58%vol. As a result, in this embodiment, it was possible to attain a high heat conductivity of approximately 19.5 W/mK and to improve heat dissipation significantly without impairing withstand voltage performance.

With the above-mentioned configuration, it is possible to obtain the module 160 in which the SiC-GTO element 20 and the SiC pn diode element 13 are connected in inverse parallel inside the package and which is equipped with the anode terminal 110, the cathode terminal 111 and the gate terminal 112 extended to the outside.
The reverse withstand voltage of the SiC-GTO module 160 according to this embodiment is approximately 5.7 kV, and the above-mentioned reverse withstand voltage was able to be maintained even at a high temperature of 250°C at which Si-GTO modules are inoperative. The leak current density at the reverse voltage of 5 kV was 2 × 10⁻⁴ A/cm² or less, an excellent value. In addition, when a current having a high current density of 200 A/cm², being difficult to be passed into Si diodes having a withstand voltage of 3 kV or more, was passed into the SiC-GTO module 160 according to this embodiment in a high temperature atmosphere of 180°C, and the module was operated for 200 hours; however, abnormalities, such as cracks and deformations, did not occur. The forward voltage during energization at a temperature of 250°C and a current density of 200 A/cm² was 4.3 V, and the change before and after the operation of 200 hours was within the measurement error range, there being almost no change.

In addition, the leak current density at a reverse voltage of 5 kV after the operation was 3 × 10⁻⁴ A/cm² or less at a temperature of 250°C, there being almost no change. Furthermore, the leak current density at a reverse voltage of 5 kV after the operation of 200 hours was 3 × 10⁻⁴ A/cm² or less at a temperature of 250°C, there being almost no change before and after the operation. This is attained because the coverings 130 and 131 formed of the synthetic polymer compound containing polymethylphenylsilsesquioxane as the first organosilicon polymer and polymethylphenylsiloxane as the second organosilicon polymer firmly attach not only to the passivation films of the SiC-GTO element and the diode element but also to the side faces of the elements on which SiC is exposed. The turn-ON time of the SiC-GTO element 20 is 0.4 microsecond and the turn-OFF time thereof is 0.7 microsecond. This turn-OFF time is one-twentieth or less of that of the silicon GTO thyristor having a withstand voltage of 6 kV, thereby being high in speed. The turn-ON time and the turn-OFF time were not changed with the passage of time. This is presumed that the temperature rise of the elements was suppressed owing to the improvement in heat dissipation due to the AIN particles mixed in the synthetic polymer compound and that deterioration was minimal. When the AIN particles were not mixed in the synthetic polymer compound, changes were found in forward voltage, leak current density and turn-OFF time.

Although the four embodiments, i.e., the first to fourth embodiments, have been described above, the present invention includes more application ranges or derived structures.

The present invention is also applicable to, for example, wide-gap semiconductor elements, such as MOS FET, junction FET, SIT, IGBT and MOS thyristor. Furthermore, the present invention is also applicable to, for example, high-frequency high-output MESFET, lateral MOSFET, junction FET, HEMT Schottky diodes, JBS (Junction Barrier controlled Schottky) diodes.

Although elements and light-receiving elements comprising SiC and GaN have been described in the above-mentioned embodiments, the present invention is also applicable to elements comprising other wide-gap semiconductor materials; more particularly, the present invention is effectively applicable to elements comprising diamond and gallium phosphorus wide-gap semiconductor materials.

In addition, the present invention is also applicable to semiconductor devices being configured such that the polarities of respective semiconductor regions are reversed, that is, the n-type region is reversed to the p-type region and the p-type region is reversed to the n-type region, as a matter of course.

The first organosilicon polymer can be arbitrarily selected from the group consisting of polyphenylsilsesquioxane, polymethylsilsesquioxane polymethylphenylsilsesquioxane, polyethylsilsesquioxane and polypropylsilsesquioxane and can be used. In addition, two or more kinds of these may also be used.

The second organosilicon polymer can be arbitrarily selected from the group consisting of polydimethylsiloxane, polydiethylsiloxane, polydiphenylsiloxane and polyphenylmethylsiloxane and can be used. In addition, two or more kinds of these may also be used.

Although the TO-type semiconductor devices having the metal caps 14, 43 and 70 have been described in the first to third embodiments, respectively, the present invention is also applicable to semiconductor devices having highly heat-resistant resin caps instead of metal caps. Furthermore, the configuration of the semiconductor device according to the present invention may be a stud-type, a flat-type, a SIP-type formed of highly heat-resistant resin, and a mold-type generally used for Si power modules, other than the TO-type. Although an optically-coupled semiconductor device has been taken as an example in the third embodiment, the present invention is also applicable similarly to a semiconductor device having only a light-emitting semiconductor element or a semiconductor device having only a light-receiving semiconductor element.

The package of the mold-type module according to the fourth embodiment, formed of the synthetic polymer compound, may be formed of other epoxy resins, Kevlar resin (brand name) and the like having high heat resistance. In addition, as the first organosilicon polymer contained in the first and/or second synthetic polymer compounds, polymethylsilsesquioxane, polyethylsilsesquioxane or polypropylsilsesquioxane may also be used instead of polymethylphenylsilsesquioxane, or two or more kinds of these polysiloxanes may also be used; as the second organosilicon polymer, polydiphenylsiloxane, polydiethylsiloxane or polydimethylsiloxane may also be used instead of polymethylphenylsiloxane, or two or more kinds of these polysiloxanes may also be used. Furthermore, as the first and/or second synthetic polymer compounds, those not containing the first organosilicon polymer but containing only the second organosilicon polymer may also be used.

Still further, as the insulating ceramic particles, insulating ceramic particles having high heat conductivity, such as Al₂O₃, polycrystalline SiC, diamond and boron nitride, other than AIN and BeO, may also be used, and similar effects can be obtained.

### INDUSTRIAL APPLICABILITY

The present invention can provide wide-gap semiconductor devices having high heat resistance and high withstand voltage, thereby being very useful in industry.

## Claims

1. A highly heat-resistant synthetic polymer compound formed by connecting at least one kind of first organosilicon polymer and at least one kind of second organosilicon polymer to prepare a third organosilicon polymer and by connecting multiple third organosilicon polymers with covalent bonds generated by an addition reaction, thereby having a three-dimensional stereostructure, wherein
said first organosilicon polymer has a crosslinked structure connected with siloxane bonds,
said second organosilicon polymer has a linear connection structure connected with siloxane bonds, and
said third organosilicon polymer has a molecular weight of 20,000 to 800,000.

2. The highly heat-resistant synthetic polymer compound according to claim 1, further containing insulating ceramic particles having high heat conductance.

3. The highly heat-resistant synthetic polymer compound according to claim 2, containing said insulating ceramic particles at a volumetric filling factor of 20 to 80%.

4. The highly heat-resistant synthetic polymer compound according to claim 1, wherein
said first organosilicon polymer is at least one kind selected from the group consisting of polyphenylsilsesquioxane, polymethylsilsesquioxane, polymethylphenylsilsesquioxane, polyethylsilsesquioxane, and polypropylsilsesquioxane, and
said second organosilicon polymer is at least one kind selected from the group consisting of polydimethylsiloxane, polydiethylsiloxane, polydiphenylsiloxane, and polymethylphenylsiloxane.

5. The highly heat-resistant synthetic polymer compound according to claim 1, wherein the molecular weight of said first organosilicon polymer is smaller than the molecular weight of said second organosilicon polymer.

6. The highly heat-resistant synthetic polymer compound according to claim 2, wherein said insulating ceramic is at least one kind selected from the group consisting of aluminum nitride, beryllium oxide, alumina, and polycrystalline SiC.

7. A semiconductor device having a synthetic polymer compound for covering a semiconductor element and at least part of electrical connection portions for electrically connecting said semiconductor element to external apparatuses, wherein
said synthetic polymer compound is formed by connecting at least one kind of first organosilicon polymer and at least one kind of second organosilicon polymer with siloxane bonds to prepare a third organosilicon polymer, and by connecting multiple third organosilicon polymers with covalent bonds generated by an addition reaction, thereby having a three-dimensional stereostructure,
said first organosilicon polymer has a crosslinked structure connected with siloxane bonds,
said second organosilicon polymer has a linear connection structure connected with siloxane bonds, and
said third organosilicon polymer has a molecular weight of 20,000 to 800,000.

8. The semiconductor device according to claim 7, wherein said synthetic polymer compound contains insulating ceramic particles having high conductance at a volumetric filling factor of 15% or more.

9. The semiconductor device according to claim 7, wherein said synthetic polymer compound contains insulating ceramic particles having high conductance at a volumetric filling factor of 20 to 80%.

10. The semiconductor device according to claim 8 or 9, wherein said insulating ceramic is at least one kind selected from the group consisting of aluminum nitride, beryllium oxide, alumina and polycrystalline SiC.

11. The semiconductor device according to claim 7, the semiconductor element thereof being a wide-gap semiconductor element selected from either one of a SiC semiconductor element comprising silicon carbide and a GaN semiconductor element comprising gallium nitride, wherein
said first organosilicon polymer is at least one kind selected from the group consisting of polyphenylsilsesquioxane, polymethylsilsesquioxane, polymethylphenylsilsesquioxane, polyethylsilsesquioxane, and polypropylsilsesquioxane, and
said second organosilicon polymer is at least one kind selected from the group consisting of polydimethylsiloxane, polydiethylsiloxane, polydiphenylsiloxane, and polymethylphenylsiloxane.

12. The semiconductor device according to claim 7, the semiconductor element thereof being a wide-gap semiconductor light-receiving element or a wide-gap semiconductor light-emitting element, or the combination of the two, wherein
said first organosilicon polymer is at least one kind selected from the group consisting of polyphenylsilsesquioxane, polymethylsilsesquioxane, polymethylphenylsilsesquioxane, polyethylsilsesquioxane, and polypropylsilsesquioxane, and
said second organosilicon polymer is at least one kind selected from the group consisting of polydimethylsiloxane, polydiethylsiloxane, polydiphenylsiloxane, and polymethylphenylsiloxane.

13. The semiconductor device according to claim 11 or 12, wherein the molecular weight of said first organosilicon polymer is smaller than the molecular weight of said second organosilicon polymer.

14. A semiconductor device comprising:
at least one semiconductor element mounted on a heat conductive substrate,
electrical connection portions for electrically connecting said semiconductor element to external apparatuses,
a first synthetic polymer compound for covering said semiconductor element and at least part of said electrical connection portions,
a package, configured so as to be combined with said substrate, for accommodating said semiconductor element and said electrical connection portions covered with said first synthetic polymer compound,
a second synthetic polymer compound filled in the space inside said package, and
external connection terminals connected to said electrical connection portions and extended to the outside of said package, wherein
said first synthetic polymer compound is formed by connecting at least one kind of first organosilicon polymer and at least one kind of second organosilicon polymer with siloxane bonds to prepare a third organosilicon polymer, by connecting multiple third organosilicon polymers with covalent bonds generated by an addition reaction, thereby having a three-dimensional stereostructure, and by containing insulating ceramic particles having high heat conductance,
said first organosilicon polymer has a crosslinked structure connected with siloxane bonds,
said second organosilicon polymer has a linear connection structure connected with siloxane bonds,
said third organosilicon polymer has a molecular weight of 20,000 to 800,000,
said second synthetic polymer compound is formed by connecting at least one kind of fourth organosilicon polymer and at least one kind of fifth organosilicon polymer with siloxane bonds to prepare a sixth organosilicon polymer, by connecting multiple sixth organosilicon polymers with covalent bonds generated by an addition reaction, thereby having a three-dimensional stereostructure, and by containing insulating ceramic particles having high heat conductance,
said fourth organosilicon polymer has a crosslinked structure connected with siloxane bonds,
said fifth organosilicon polymer has a linear connection structure connected with siloxane bonds, and
said sixth organosilicon polymer has a molecular weight of 20,000 to 800,000.

15. The semiconductor device according to claim 14, wherein the flexibility of said second synthetic polymer compound is higher than that of said first synthetic polymer compound.

16. The semiconductor device according to claim 14, the semiconductor element thereof being a wide-gap semiconductor element selected from either one of a SiC semiconductor element comprising silicon carbide and a GaN semiconductor element comprising gallium nitride, wherein
said first organosilicon polymer and said fourth organosilicon polymer are at least one kind selected from the group consisting of polyphenylsilsesquioxane, polymethylsilsesquioxane, polymethylphenylsilsesquioxane, polyethylsilsesquioxane, and polypropylsilsesquioxane, and
said second organosilicon polymer and said fifth organosilicon polymer are at least one kind selected from the group consisting of polydimethylsiloxane, polydiethylsiloxane, polydiphenylsiloxane, and polymethylphenylsiloxane.

17. The semiconductor device according to claim 14, wherein
the semiconductor elements thereof are a SiC-GTO element and a SiC diode element, and
said two elements are connected in inverse parallel by using electrical connection portions inside said package.
